# FASCICULE DE BREVET EUROPEEN

(11) **EP 0 543 712 B1**
(45) Date de publication et mention de la délivrance du brevet: **27.10.1999**
(21) Numéro de dépôt: 92403072.9
(22) Date de dépôt: 16.11.1992
(51) Int. Cl.: G06F 12/12, G06F 12/08, G06F 11/00, G06F 11/08

(54) **Mémoire intégrée, son procédé de gestion et système informatique en résultant**
Integrierter Speicher, Verwaltungsverfahren und resultierendes Informationssystem
Integrated memory, method of control and resulting information system

(30) Priorité: 18.11.1991 FR 9114182
(43) Date de publication de la demande: 26.05.1993
(73) Titulaire: BULL S.A., 78434 Louveciennes Cedex (FR)
(72) Inventeur: Charlot, Didier, F-38000 Grenoble (FR); Keryvel, Josiane, F-78000 Versailles (FR); Bernard, Christian, F-78340 Les Clayes sous Bois (FR)
(74) Mandataire: Denis, Hervé

(56) Documents cités:
- EP-A- 0 287 334
- EP-A- 0 398 521
- EP-A- 0 407 067
- US-A- 4 562 536
- US-A- 4 744 049
- US-A- 4 809 276

## Description

L'invention se rapporte à un procédé de gestion d'une mémoire électronique intégrée pouvant inclure des défauts, à la mémoire en résultant et au système mettant en oeuvre ce procédé. L'invention s'applique plus particulièrement aux systèmes informatiques et aux antémémoires de ces systèmes.

Un système informatique est constitué d'un sous-système central pouvant communiquer avec un ou plusieurs sous-systèmes périphériques par l'intermédiaire d'unités d'entrée-sortie. Le sous-système central d'un grand système comprend ordinairement plusieurs processeurs reliés par un bus à une mémoire centrale et aux unités d'entrée-sortie.

Chaque processeur a pour fonction l'exécution des instructions des programmes contenus dans la mémoire centrale. Ces instructions et les données nécessaires à leur exécution sont accessibles par le processeur en utilisant les moyens d'adressage de la mémoire centrale. Cependant, compte tenu des temps d'accès relativement longs dans la mémoire centrale, les processeurs sont habituellement munis d'une antémémoire (cache memory) beaucoup plus rapide mais de contenu limité à un certain nombre d'extraits du contenu de la mémoire centrale. Une antémémoire se compose d'une mémoire de données et d'un répertoire des adresses de ces données. La mémoire de données est faite généralement d'une mémoire vive statique (SRAM) et constitue une mémoire associative à niveaux. Elle est divisée en blocs ayant une même taille prédéterminée et correspondant chacun à un quantum d'échange avec la mémoire centrale. Les blocs sont organisés en N colonnes de n niveaux. N blocs consécutifs constituent une page de l'antémémoire, qui contient donc au total n pages. L'adresse d'un bloc dans une page correspond ainsi à une colonne. Cependant, un bloc sous une adresse donnée peut être placé dans un niveau quelconque de la colonne. Le niveau d'un bloc est déterminé en effectuant une comparaison avec les adresses des pages de la colonne. Afin de diminuer la durée de recherche d'un bloc, on donne un petit nombre de niveaux à chaque colonne, ordinairement deux ou quatre.

Un processeur est composé de divers circuits de traitement. On trouvera par exemple une description de ces circuits adaptés à un processeur microprogrammé dans la demande de brevet de la demanderesse EP-A-0434483. Dans ce document, les processeurs étaient connectés par l'intermédiaire de leur antémémoire à un bus leur permettant de communiquer avec la mémoire centrale. Chaque processeur et son antémémoire résidaient ensemble sur une même carte de circuits imprimés reliant plusieurs boîtiers de circuits intégrés.

La capacité d'intégration sans cesse croissante des circuits permet aujourd'hui d'intégrer chaque processeur dans une puce et d'y associer une partie d'antémémoire, appelée antémémoire privée. Les antémémoires privées sont connectées à une partie extérieure d'antémémoire, appelée antémémoire partagée et connectée au bus. Une antémémoire privée se compose aussi d'une mémoire de données et d'un répertoire d'adresse.

L'invention se rapporte au problème posé par les défauts des composants et/ou des circuits de la mémoire. Pour y remédier, il est connu d'ajouter des composants et des circuits de réserve et de reconfigurer les circuits de la mémoire. La reconfiguration consiste à déconnecter la partie défectueuse et à la suppléer en utilisant les circuits et les composants de réserve. Selon une autre solution, des parties fonctionnelles redondante telles que des blocs de mémoire sont ajoutées et utilisées à la place de parties correspondantes défectueuses. Un décodeur est ajouté au répertoire de la mémoire pour allocation des parties redondantes.

Ces deux solutions ont l'inconvénient d'ajouter des composants et des circuits et d'encombrer par conséquent la surface utile de la mémoire. Pour augmenter les performances d'un circuit intégré, les concepteurs visent toujours à profiter au maximum de la surface utile et répugnent à concéder une partie de la surface pour suppléer à des défauts éventuels dans la mémoire. C'est le cas notamment d'une mémoire associée à un circuit de traitement dans un même circuit intégré, tel que celui de l'exemple précédent. Dans cet exemple, l'antémémoire recouvre environ les deux tiers de la surface et doit laisser la place nécessaire au processeur. La reconfiguration des circuits a en outre l'inconvénient de recourir à des techniques sophistiquées coûteuses et longues, telles que notamment les techniques de connexion et de déconnexion par laser, ou bien de rajouter des éléments interrupteurs dans la mémoire pour la connexion et la déconnexion de certaines parties de la mémoire. La redondance a aussi comme autre inconvénient de compliquer le décodeur du répertoire afin de modifier l'adressage dans les éléments de réserve activés.

Le document EP-A-0 287 334 décrit une antémémoire associative par jeux composée de cellules comprenant chacune un champ d'état pourvu d'un bit de force qui, en position active, indique une cellule défaillante. La sortie de la cellule défaillante est alors supprimée, aucune donnée ne pouvant y être mémorisée. Le champ d'état contient également un bit représentatif de l'état de modification de la cellule correspondante. En d'autres termes, ce document enseigne l'interdiction de l'accès à des blocs inutilisables à cause de défauts de fonctionnement, en associant les blocs inutilisables à des marques respectives.

Le document EP-A-0 407 067 décrit un système de traitement de données contenant une mémoire commune à plusieurs processeurs, chaque bloc de la mémoire comportant un champ d'état dont deux bits constituent un champ de statut représentatif des quatre états possibles du bloc, l'un d'eux indiquant la présence d'un défaut irréparable dans le bloc.

Le document EP-A-0 398 521 décrit un système mémoire divisé en blocs disposés en un nombre égal de lignes et colonnes, de sorte que si le test d'initialisation de la mémoire fait apparaître que la capacité disponible de la mémoire n'atteint pas la capacité désirée, les adresses de colonnes et de rangées sont inversées et le test est recommencé pour vérifier si l'inversion a pu concentrer les erreurs le long d'une ligne d'adresse et accroître ainsi la capacité disponible de la mémoire.

Enfin, le document US-A-4 562 536 décrit un système d'antémémoire associative par jeux à plusieurs niveaux, dont le répertoire inclut un dispositif de vérification d'erreur générant des bits de vérification d'adresse qui sont écrits dans le répertoire avec les adresses, la détection d'une erreur dégradant le fonctionnement aux niveaux ne contenant pas d'erreur.

L'invention a pour but de permettre l'utilisation d'une mémoire contenant des défauts sans avoir à rajouter des composants et/ou des circuits supplémentaires et sans compliquer le répertoire.

Le procédé conforme à l'invention est défini par la revendication 1.

La mémoire intégrée qui en résulte est définie par la revendication 5.

L'invention s'applique plus particulièrement à un système informatique tel que défini par la revendication 10.

Les caractéristiques et avantages de l'invention ressortiront de la description qui suit, donnée à titre d'exemple et faite en référence aux dessins annexés.

Dans les dessins :
- la figure 1 est une vue synoptique d'un système informatique conforme à l'invention, comprenant des processeurs incluant chacun une antémémoire privée conforme à l'invention, gérée selon le procédé de l'invention ;
- la figure 2 est une vue schématique d'un processeur du système informatique représenté sur la figure 1 ;
- la figure 3 illustre schématiquement un exemple d'organisation de la mémoire de données de l'antémémoire privée du processeur représenté sur la figure 2 ;
- la figure 4 illustre schématiquement un exemple d'organisation du registre d'adresse de l'antémémoire privée du processeur représenté sur la figure 2 ;
- la figure 5 illustre la structure des adresses mises en oeuvre dans l'antémémoire représentée sur les figures 3 et 4 et leurs relations entre elles ;
- la figure 6 illustre un mode de réalisation du procédé conforme à l'invention pour le marquage des blocs de la mémoire de données ;
- la figure 7 illustre schématiquement les liens existant entre la mémoire de données et le registre de l'antémémoire et les unités EAD et BDP du processeur pour la mise en oeuvre du procédé d'autotest servant à faire le marquage du procédé conforme à l'invention ; et
- les figures 8 et 9A-9B présentent respectivement des organigrammes d'exécution des unités EAD et BDP pour la mise en oeuvre du procédé d'autotest décrit en référence à la figure 7.

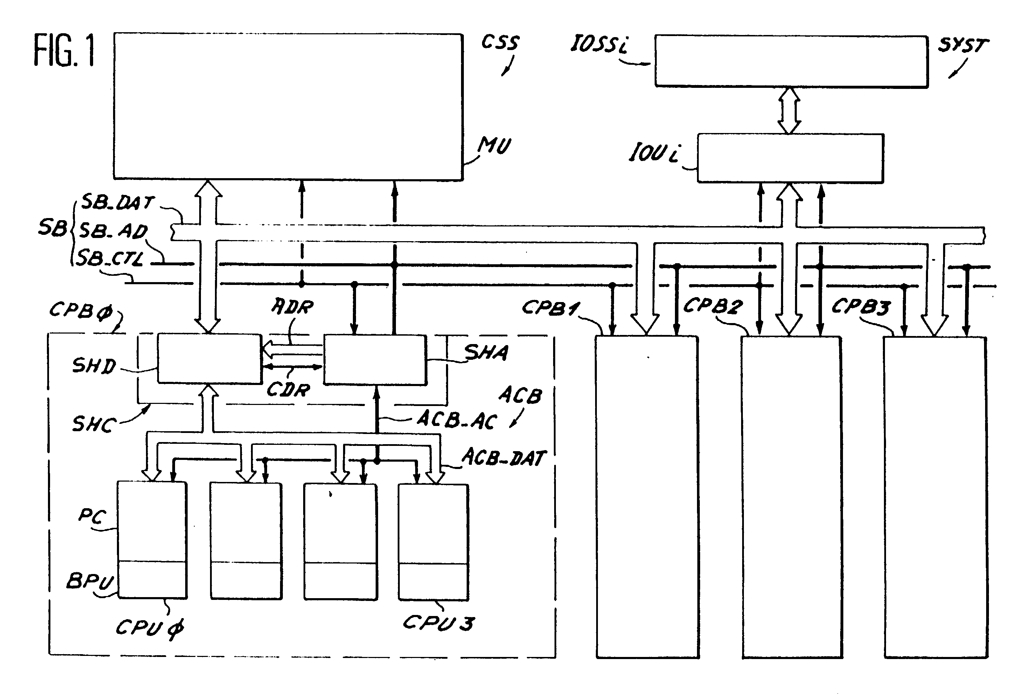

La figure 1 est une vue synoptique d'un système informatique SYST comprenant un sous-système central CSS conforme à l'invention connecté à plusieurs sous-systèmes périphériques IOSSi. Le sous-système central CSS comprend une mémoire centrale MU connectée à un bus système SB pour communiquer avec seize processeurs CPU (CPU0, CPU1,...) et avec des unités d'entrée-sortie IOUi reliées aux sous-systèmes périphériques IOSSi respectifs. Le bus SB se compose d'un bus de données SB-DAT, d'un bus d'adresse SB-AD et d'un bus de commande SB-CTL. Les seize processeurs CPU sont répartis sur quatre plaques CPB (Central Processor Board) CPB0-CPB3 de quatre processeurs chacun. Sur chaque plaque CPB, chacun des quatre processeurs CPU0-CPU3 est fait d'un circuit intégré VLSI (Very Large Scale Integration) comprenant une antémémoire privée PC et une unité de traitement de base BPU, comme illustré en particulier sur la plaque CPB0. Chaque plaque CPB porte aussi une antémémoire partagée SHC reliant le bus système SB à un bus processeur ACB connecté aux quatre antémémoires privées PC des processeurs CPU. Le bus processeur ACB comprend un bus de données ACB-DAT et un bus d'adresse et de commande multiplexées ACB-AC. L'antémémoire partagée SHC se compose d'une mémoire de données SHD et d'un registre d'adresse SHA. La mémoire de données SHD est connectée au bus de données SB-DAT du bus système SB et aux quatre antémémoires privées PC par l'intermédiaire du bus de données ACB-DAT. Le registre SHA relie le bus d'adresse SB-AD et le bus de commande SB-CTL du bus système SB au bus d'adresse et de commande multiplexées ACB-AC du bus processeur ACB. Le registre SHA commande la mémoire de données SHD par des lignes d'adresse ADR et des lignes de commande interne CDR.

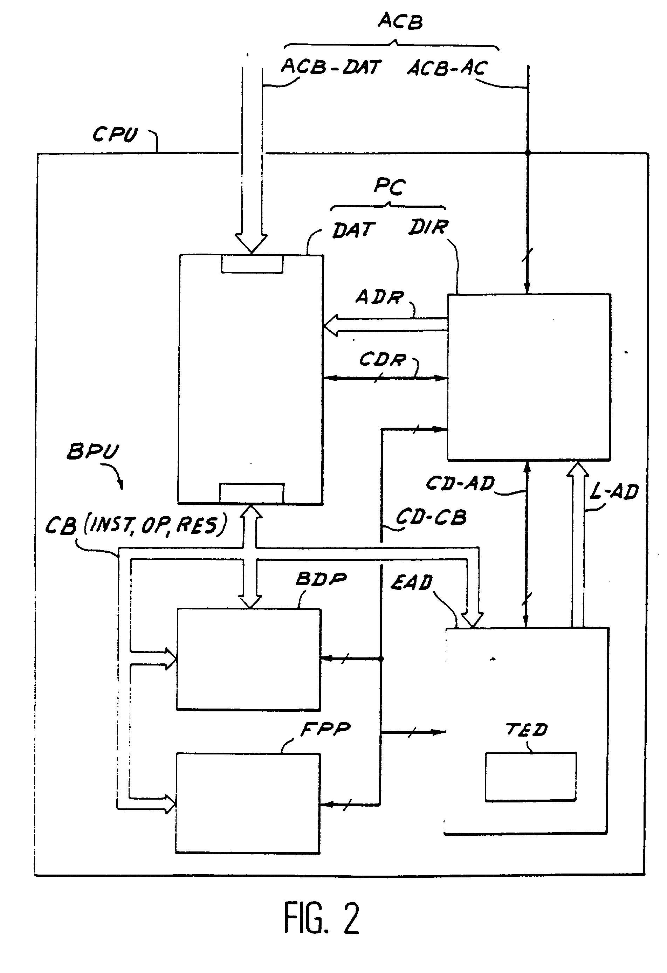

La figure 2 illustre schématiquement la structure de l'un des seize processeurs CPU d'une plaque CPB du sous-système central CSS. L'antémémoire privée PC se compose de manière classique d'une mémoire de données DAT et d'un répertoire DIR des adresses des données dans la mémoire DAT. La mémoire DAT est typiquement une mémoire associative faite de blocs organisés en N colonnes de n niveaux. Le nombre n de niveaux est déterminé par le rapport de la capacité totale de la mémoire DAT au produit du nombre N de colonnes avec la taille d'un bloc. La mémoire DAT échange des données avec le bus processeur ACB par l'intermédiaire du bus de données ACB-DAT. Le répertoire DIR communique avec les trois autres processeurs de la carte et avec le registre d'adresse SHA de l'antémémoire partagée SHC par l'intermédiaire du bus d'adresse et de commande multiplexées ACB-AC. D'autre part, comme dans l'antémémoire partagée SHC, le répertoire DIR commande la mémoire DAT par des lignes d'adresse ADR et des lignes de commande interne CDR.

L'unité de traitement de base BPU de chaque processeur illustré comprend trois unités d'exécution du processeur : une unité EAD (Effective Address Development) de traduction des adresses virtuelles en adresses réelles et d'adressage de l'antémémoire privée PC ; une unité BDP (Binary-Decimal Processor) de calcul binaire et décimal ; et une unité FPP (Floating Point Processor) de calcul à virgule flottante. Ces trois unités sont reliées entre elles et avec la mémoire DAT par un bus interne CB. Le bus interne CB comprend un bus INST pour transmettre les instructions émises par la mémoire DAT, un bus OP pour transmettre les opérandes émis par la mémoire DAT, et d'un bus RES de quatre octets pour écrire des résultats dans la mémoire DAT à partir de l'une des trois unités EAD, BDP et FPP ou pour l'échange de résultats entre ces trois unités. En particulier, l'unité EAD est spécifiquement affectée aux opérations d'adressage pour l'obtention notamment des instructions et des opérandes à partir de l'antémémoire privée PC. Elle incorpore une table des extraits de descripteurs TED pour le calcul des adresses réelles AD qu'elle envoie au registre DIR par des lignes d'adresse L-AD. Elle échange aussi avec lui des signaux de commande d'adressage CD-AD. Le registre DIR réagit aux signaux CD-AD pour commander la mémoire DAT par l'intermédiaire des lignes ADR et CDR. La mémoire DAT peut alors échanger les instructions, les opérandes et les résultats avec les unités EAD, BDP et FPP par l'intermédiaire du bus interne CB. Comme ces unités peuvent exécuter de façon autonome leur propre microprogramme dans chaque processeur CPU , elles sont reliées entre elles et avec le registre DIR par des lignes de commande CD-CB pour la synchronisation et la cohérence des opérations qu'elles effectuent. Cet exemple n'est donné qu'à titre illustratif d'un mode de réalisation préféré d'un processeur adapté à mettre en oeuvre l'invention. Pour des raisons de clarté, les figures 1 et 2 ne représentent pas les circuits d'horloge et les dispositifs de maintenance. On trouvera un exemple de fonctionnement microprogrammé d'une structure similaire de sous-système central d'informatique dans le document précité EP-A-0434483.

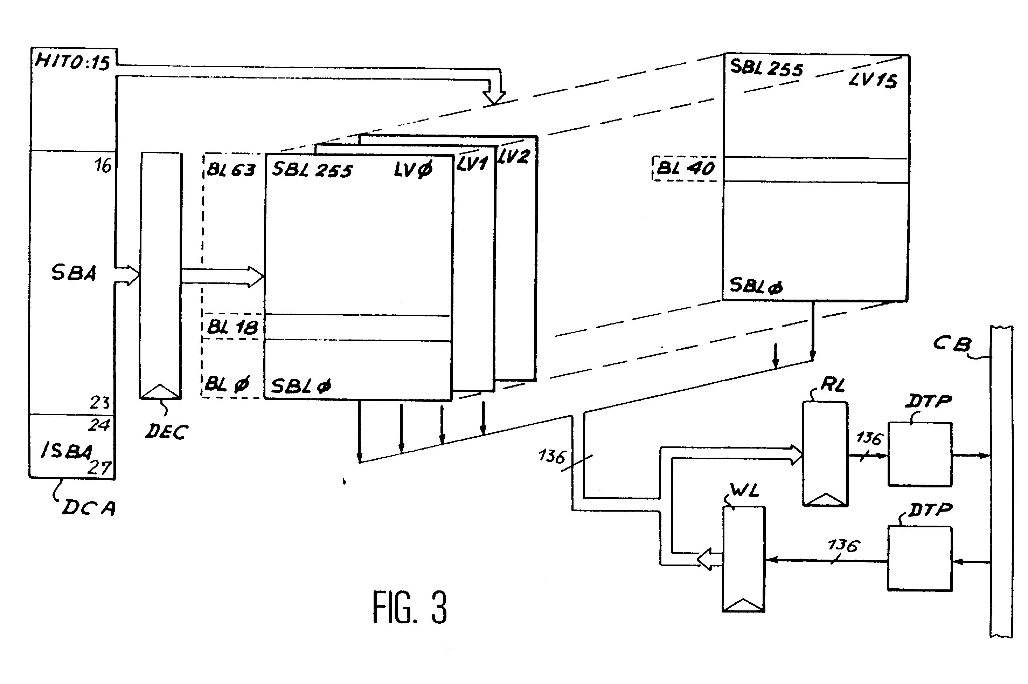

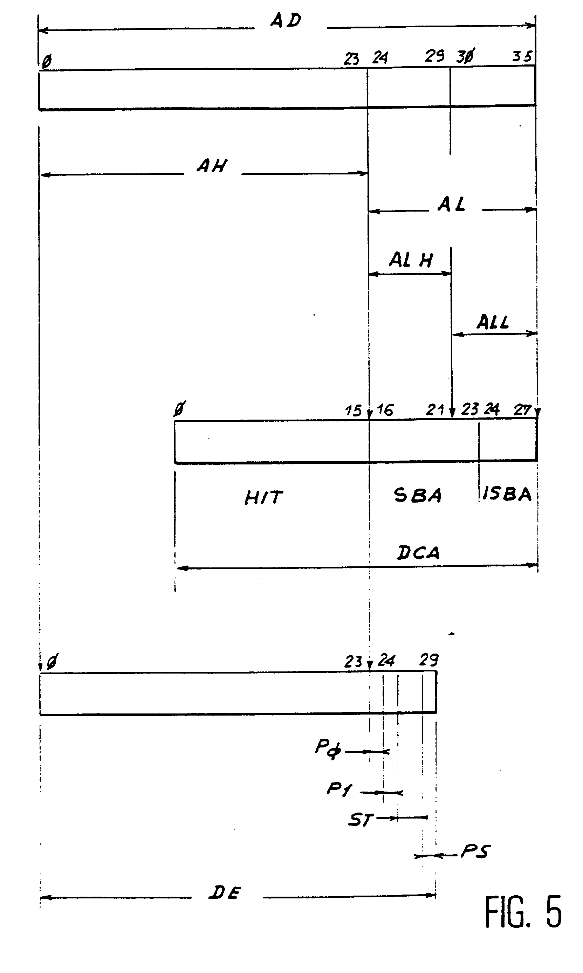

Le mode préféré de réalisation du procédé de gestion de l'antémémoire PC va maintenant être décrit à titre d'exemple en référence aux figures 3 à 6. La figure 3 illustre l'organisation de la mémoire DAT, d'une capacité totale de 2¹⁶ octets, soit 64 ko. Elle est organisée en soixante-quatre colonnes de seize niveaux LV0-LV15. Chaque niveau contient donc 64 blocs BL0-BL63 ayant chacun une taille de 2⁶ octets, soit 64 octets, et une colonne est faite des seize blocs correspondants dans les seize niveaux. Par exemple, la colonne 12 se compose des seize blocs BL12 des seize niveaux LV0-LV15. Les 64 blocs se composent chacun de quatre sous-blocs SBL de 16 octets et définissent ainsi 256 sous-blocs SBL0-255 dans chacun des seize niveaux LV0-LV15. La mémoire DAT reçoit du registre DIR par l'intermédiaire des lignes d'adressage ADR les adresses des sous-blocs. La figure 5 illustre un exemple de ces adresses, référencées DCA (Data Cache memory Address). Les seize premiers bits HIT 0:15 de l'adresse DCA, non codés, seront présentés ultérieurement et définissent les seize niveaux LV0-LV15 de la mémoire DAT. Ces seize bits s'ajoutent à huit bits SBA 16:23 représentatifs de l'adresse d'un sous-bloc SBL et à quatre bits ISBA 24:27 pour l'adressage à l'intérieur d'un sous-bloc. Les huit bits SBA sont décodés dans la mémoire DAT par un décodeur DEC. Chaque adresse DCA contient donc l'information dont la mémoire DAT a besoin pour accéder au sous-bloc qui fournira les données à l'unité de traitement BPU par l'intermédiaire du bus CB. Dans la mémoire DAT, les données sont fournies à des lignes de données de 136 bits (16 octets représentatifs de la taille d'un sous-bloc + 1 octet de parité) associées à un registre d'écriture WL et à un registre de lecture RL respectivement connectés à des chemins de données DTP servant de circuits d'interface avec le bus CB.

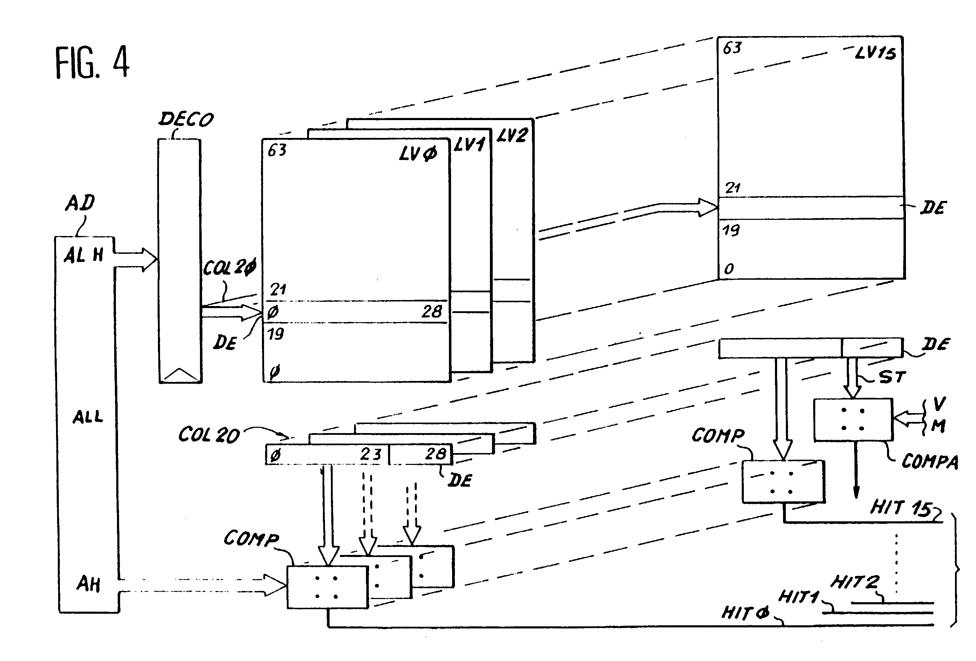

La figure 4 illustre schématiquement l'organisation et le fonctionnement du registre DIR. Le registre DIR illustré est une mémoire vive prévue pour le stockage des adresses DE des blocs de la mémoire DAT. La mémoire de DIR est donc aussi composée de blocs organisés en soixante-quatre colonnes COL0-63 de seize niveaux LV0-LV15 et prévus pour stocker les adresses respectives DE des blocs BL de la mémoire DAT. Les adresses DE stockées dans le registre DIR sont issues des adresses AD que le registre reçoit de l'unité EAD.

La figure 5 illustre un exemple d'adresse AD fournie par l'unité EAD au registre DIR pour l'adressage d'un bloc. L'adresse AD comprend une adresse haute AH faite des bits de poids forts et une adresse basse AL faite des bits de poids faibles. L'adresse haute AH se compose de vingt-quatre bits 00:23 fournis par l'unité EAD après traitement dans sa table des extraits de descripteurs TED. L'adresse haute AH définit la page dans laquelle se trouve le bloc. L'adresse AD illustrée suppose que chaque page de mémoire logicielle a une taille de 2¹² octets, soit 4ko. L'unité EAD fournit sans transformation, donc rapidement, les douze bits 24:35 de l'adresse basse AL, qui correspondent à la puissance des 2¹² octets de la taille de page de mémoire logicielle. L'adresse basse AL se divise en six bits 24:29 d'adresse haute ALH pour l'adressage du bloc dans la page et en six bits 30:35 d'adresse basse ALL pour l'adressage à l'intérieur d'un bloc.

La figure 5 illustre la formation de l'adresse DCA d'un sous-bloc de la mémoire DAT à partir de l'adresse AD. On a vu que la mémoire du registre DIR est organisée en blocs de 64 octets et que dans la mémoire DAT les blocs BL se décomposent chacun en quatre sous-blocs SBL de 16 octets. Pour l'adressage d'un sous-bloc SBL dans la mémoire DAT, les douze bits de l'adresse basse AL sont donc répartis en huit bits de poids forts constituant l'adresse SBA du sous-bloc, et en quatre bits de poids faibles constituant l'adresse ISBA à l'intérieur du sous-bloc.

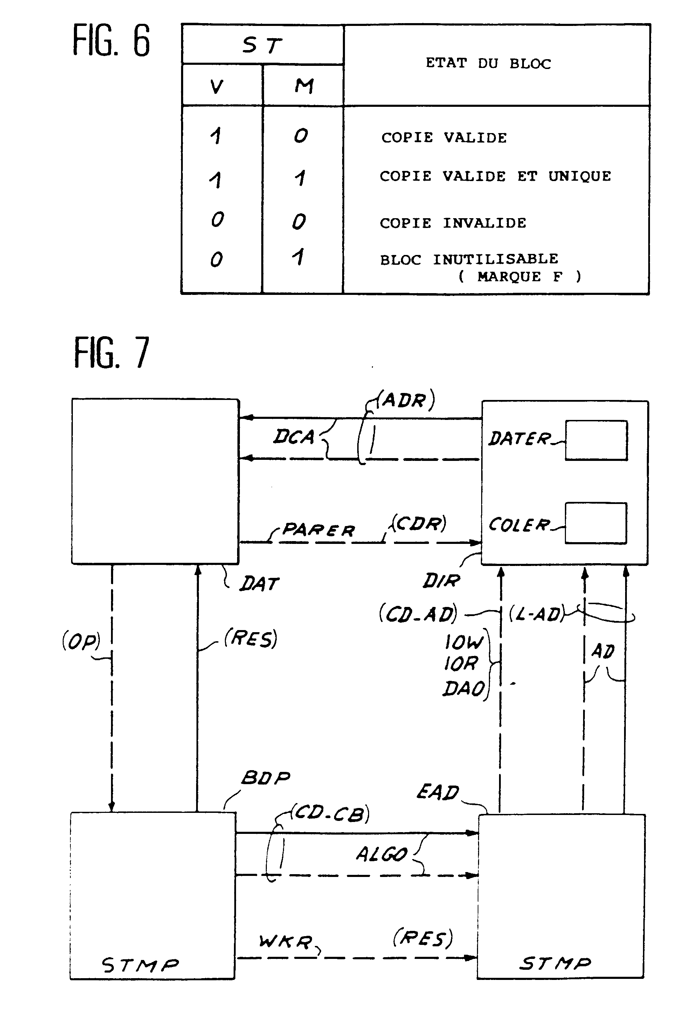

La figure 5 illustre aussi un exemple d'adresse DE (Directory Entry) que stocke le registre DIR après réception de l'adresse AD fournie par l'unité EAD. L'adresse d'entrée DE se compose d'un champ d'adresse formé des vingt-quatre bits 00:23 de l'adresse haute AH de l'adresse AD, d'un bit 24 de parité P0 des bits 00:11 du champ d'adresse, d'un bit 25 de parité P1 des bits restants 12:12 du champ d'adresse, de deux bits 26, 27 représentatifs de l'état ST du bloc, et d'un bit 28 de parité d'état PS. De manière classique, l'état ST est déterminé par les deux bits appelés V (Valide) et M (Modifié) définissant trois états de la façon représentée sur la figure 6 : un état de copie valide 10 quand l'antémémoire privée PC à la même copie du bloc qui se trouve dans l'antémémoire partagée SHC, la même copie pouvant se trouver dans d'autres antémémoires privées PC des processeurs CPU ; un état de copie valide modifiée 11 si l'antémémoire privée PC est seule à avoir la copie du bloc qu'elle a modifiée (les copies qui se trouvent dans les autres antémémoires privées PC, ou dans l'antémémoire partagée SHC ou dans la mémoire centrale MU n'étant pas à jour) ; et un état de copie invalide 00 quand l'antémémoire privée PC a eu une copie du bloc mais l'a perdue, par exemple si un autre processeur CPU a entre temps écrit dans ce bloc. Le bit de parité d'état PS est le résultat de la somme par OU Exclusif des bits V, M et de la partie haute ALH de l'adresse basse AL. L'adresse d'entrée DE n'incorpore donc pas l'adresse basse AL reçue de l'unité EAD. En pratique, le registre DIR gère des blocs de 64 octets et peut donc transmettre directement la partie basse ALL de l'adresse basse AL à la mémoire DAT, tandis que la partie haute ALH sert directement pour adresser une colonne du registre DIR.

La figure 4 illustre le principe de fonctionnement du registre DIR. Les six bits ALH de l'adresse basse AL de l'adresse AD reçue de l'unité EAD sont décodés par un décodeur DECO en soixante-quatre bits désignant l'une des soixante-quatre colonnes COL0-63 où se trouve l'adresse DE recherchée. Cette adresse est à rechercher parmi les seize adresses DE contenues dans les seize niveaux LV0-LV15 de la colonne désignée par le décodeur DEC, la colonne COL20 dans l'exemple illustré. La recherche de l'adresse se fait en comparant dans seize comparateurs COMP le champ d'adresse 00:23 de chacune des seize adresses DE de la colonne COL20 avec l'adresse haute AH de l'adresse AD. Les seize résultats HIT0:15 définissent donc le niveau dans lequel le bloc se trouve dans la mémoire DAT. On supposera à titre d'exemple dans la figure 4 que l'adresse se trouve dans le niveau LV15. Les seize résultats HIT0:15 constituent les seize premiers bits de l'adresse DCA (figure 5) envoyée par le registre DIR à la mémoire DAT. Les bits HIT0-15 pourraient être codés en un signal de quatre bits, qui serait décodé dans la mémoire DAT. Mais le temps nécessaire au codage et au décodage retarderait leur utilisation par la mémoire DAT. L'envoi par le registre DIR des bits HIT0:15 déterminant dans la mémoire DAT le niveau du bloc demandé par l'unité EAD (le niveau LV15 dans l'exemple illustré) se fait après vérification de l'état ST du bloc BL dans un comparateur COMPA. On a vu en référence à la figure 6 que l'état ST est défini par les deux bits V et M de l'adresse DE du bloc BL. Si le processeur CPU veut lire dans le bloc BL de la mémoire DAT, il suffit que le bloc ait un état valide (V = 1). Le comparateur COMPA vérifie donc la valeur du bit V dans l'adresse DE trouvée par DIR. Si V = 1, le registre DIR envoie à la mémoire DAT l'adresse DCA pour lire dans le bloc correspondant. Si V = 0 ou si aucune des seize comparaisons faites par les comparateurs COMP ne désigne aucun bloc, le registre DIR demande à l'antémémoire partagée SHC le bloc recherché BL par l'intermédiaire du bus ACB-AC (figure 2). Le registre DIR cherche alors dans la mémoire DAT un niveau pour stocker le bloc BL qui sera reçu de l'antémémoire partagée SHC. On verra ultérieurement que ce niveau est sélectionné par un opérateur utilisant un algorithme de remplacement des blocs. Si l'état du bloc BL à remplacer est V = 1, M = 1, l'antémémoire privée PC est seule à avoir une copie à jour de ce bloc. Il faut donc envoyer les données de ce bloc à l'antémémoire partagée SHC, cet envoi étant connue sous le nom "swap". Les données du nouveau bloc BL sont reçues du bus ACB-DAT. Le registre DIR envoie alors à la mémoire DAT l'adresse DCA pour que la mémoire DAT range ce bloc et lise dans ce même bloc les données à envoyer au processeur CPU. Si, par contre, le processeur CPU veut écrire dans un bloc BL de la mémoire DAT, il faut qu'il ait une copie valide et unique de ce bloc. Le comparateur COMPA vérifie donc l'état du bit V pour savoir si le bloc est valide, puis il vérifie l'état du bit M. Si M = 1, l'écriture peut se faire et le registre DIR envoie l'adresse DCA à la mémoire DAT. Si M = 0, le registre DIR doit s'assurer que les autres processeurs n'ont pas modifié la copie qui est dans la mémoire DAT. Si non, l'écriture peut se faire et si oui, le registre DIR agit pour la mise à jour du bloc avant d'écrire dans le bloc.

Comme indiqué dans la mémoire DAT représentée sur la figure 3, on a supposé que notamment le bloc BL18 du niveau LV0 et le bloc BL 40 du niveau LV15 présentent des défauts de fabrication qui les rendent inutilisables. Un défaut dans un seul sous-bloc suffit pour que le bloc soit déclaré inutilisable.

L'invention consiste à utiliser la mémoire DAT avec des défauts, sans remplacement ou réparation de ces défauts. Selon une caractéristique connue, la présence d'un défaut dans l'emplacement réservé à un bloc se traduit dans l'adresse par une marque F signifiant que ce bloc est inutilisable. Dans l'adresse DE représentée sur la figure 5, la marque F est constituée par la combinaison inutilisée 01 des bits V et M définissant l'état ST du bloc, comme indiqué à la figure 6. Dans ce cas, la marque F n'est mise que si le bloc est inutilisable. S'il est fonctionnellement utilisable, les bits V et M servent à indiquer l'un des trois-états ST du bloc.

Il est clair que les performances de la mémoire DAT dépendent du nombre de ses blocs inutilisables. Une caractéristique de l'invention consiste à limiter le nombre des blocs inutilisables dans une proportion prédéterminée. Cette proportion peut se référer au nombre total des blocs de la mémoire DAT. Il a été choisi dans le présent exemple de limiter le nombre de blocs inutilisables à 10, ce qui représente un pourcentage d'environ 1% de blocs inutilisés dans la mémoire DAT. Cependant, si ces dix blocs se trouvaient dans la même colonne, les six niveaux encore disponibles dans cette colonne limiteraient sérieusement les performances de la mémoire. Par conséquent, il est souhaitable de donner une seconde limitation relative au nombre maximal de blocs inutilisables dans chaque colonne. Cette limitation dépend évidemment du nombre de niveaux attribués à chaque colonne. Si la mémoire DAT était organisée de manière classique en seulement deux niveaux par exemple, la présence d'un bloc inutilisable dans une colonne ne laisserait plus qu'un seul niveau utilisable et réduirait notablement les performances de l'antémémoire. Même avec une organisation classique de quatre niveaux, le choix serait plus grand mais il est souhaitable en pratique que le nombre de blocs inutilisables dans une colonne soit au minimum de deux pour tenir compte par exemple de défauts de technologie chevauchant deux blocs. Ceci réduit notablement le nombre de circuits intégrés inutilisables et le coût de cette perte. Dans ce cas, l'organisation à quatre niveaux ne laisserait plus que deux niveaux utilisables. L'organisation à seize niveaux qui est illustrée offre un bon compromis entre le nombre de comparaisons à faire, les performances désirées et la réduction du coût des pertes.

Dans toute antémémoire, le remplacement des blocs est fait par un algorithme choisi parmi plusieurs types possibles bien connus. Dans l'exemple illustré, l'algorithme utilisé est connu sous le nom de LRU (Last Recently Used), qui désigne comme bloc à remplacer le bloc qui a été le plus anciennement référencé dans DAT. Dans le cas présent, on a vu que si le processeur fait une requête sur un bloc, il accède au registre DIR avec l'adresse de ce bloc. Le registre DIR fait alors une comparaison dans les seize niveaux de la colonne pour voir si le bloc est présent (figure 4). En cas de succès, aucun problème ne se pose. En cas d'insuccès, le registre DIR doit chercher le bloc dans l'antémémoire partagée SC qui, si elle ne l'a pas, le cherchera dans la mémoire centrale MU. Pendant ce temps, l'algorithme LRU choisit un niveau parmi le nombre de niveaux possibles. Dans une mémoire associative classique, ce nombre correspond au nombre n de niveaux choisit pour l'organisation de la mémoire. Mais dans l'antémémoire gérée conformément au procédé de l'invention, il ne faut pas que l'algorithme choisisse un niveau inutilisable. Selon une solution préférée, le registre DIR envoie à l'algorithme un masque des seize niveaux de la colonne. Le masque contient les copies des bits V et M des seize adresses DE contenues dans la colonne. S'il y a dans ce masque la marque F d'un ou de deux blocs inutilisables, l'algorithme en tiendra compte pour choisir le niveau réservé au bloc qu'il va recevoir.

Dans le mode réalisation illustré, les marques F sont disposées dans les adresses DE stockées dans la mémoire vive du registre DIR. Par conséquent, les marques F sont perdues avec les adresses DE à chaque interruption de fonctionnement du sous-système central CSS. Il faut donc placer les marques F à chaque initialisation du sous-système central CSS. Elles pourraient être par exemple extraites d'une petite mémoire morte interne ou externe à l'antémémoire privée PC ou au circuit intégré l'incorporant, par exemple associée à l'antémémoire partagée SHC. Dans ce cas, l'algorithme LRU pourrait simplement consulter cette petite mémoire morte et n'aurait pas besoin du masque envoyé par le registre DIR.

La description du mode de réalisation préféré de l'invention suggère à l'évidence pour l'homme du métier que l'invention peut recevoir de nombreuses variantes et applications. Par exemple, il est clair que l'invention pourrait s'appliquer aussi bien à l'antémémoire partagée SHC, comme à toute sorte d'antémémoire d'un ou plusieurs processeurs d'un système informatique. Mais une antémémoire est une mémoire associative à niveaux, de sorte que le procédé de l'invention peut s'appliquer de la même façon à toute mémoire associative à niveaux. D'une manière plus générale, les blocs disposés selon une grille matricielle dans la mémoire DAT pourraient aussi bien être des cellules d'une mémoire, et il ressort alors à l'évidence pour l'homme du métier que le procédé de gestion de l'invention peut s'appliquer aussi bien à une mémoire associative qu'à une mémoire adressable. Les blocs utilisés dans la description précédente ont donc une signification plus générale et peuvent être des cellules d'une mémoire adressable ou associative. Le registre DIR serait alors le circuit de commande de la mémoire.

Par conséquent, de façon générale, quand une mémoire met en oeuvre l'invention, des blocs (ou cellules) peuvent ne pas être utilisés. Accessoirement, la mémoire peut inclure des marques F représentatives du non emploi de ces blocs. Dans l'exemple illustré, ces marques sont incluses dans les adresses de ces blocs. Cependant, on a vu qu'elles pouvaient être incorporées dans une mémoire morte extérieure à la mémoire ou même au circuit intégré qui l'incorpore. La mémoire morte pourrait être lue à chaque fois qu'une adresse est demandée par l'unité EAD ou, plus avantageusement, son contenu pourrait être lu lors de l'initialisation du système SYST pour être introduit dans les adresses du registre DIR et, dans le cas d'une antémémoire, pour être fournies à l'algorithme de remplacement des blocs. Par ailleurs, la marque F faite dans l'exemple illustré utilisait avantageusement une combinaison libre des deux bits V et M indiquant l'état ST du bloc associé. Il est clair cependant que la marque pourrait aussi prendre la forme d'un bit supplémentaire F dans chaque adresse DE. Dans ce cas, les deux valeurs du bit F indiqueraient que le bloc est utilisable ou non utilisable. Le comparateur COMPA commencerait par vérifier la valeur du bit F avant de rechercher l'état ST du bloc. Le masque envoyé par le registre DIR à l'algorithme LRU ne contiendrait que les bits F. Enfin, la proportion indiquée dans l'exemple illustré peut varier et prendre diverses formes selon l'usage de la mémoire associative. Elle pourrait simplement porter sur l'ensemble des blocs ou sur un nombre prédéterminé de blocs inutilisables dans chaque colonne, ou sur un autre critère propre au fonctionnement et/ou au contexte d'utilisation de la mémoire par exemple.

Le marquage des blocs inutilisés peut se faire de différentes manières. L'invention présente un mode de réalisation préféré d'un procédé d'autotest de la mémoire DAT pour écrire dans les adresses des blocs inutilisés les marques F sous la forme décrite en référence à la figure 6.

On a vu que l'unité de traitement de base BPU d'un processeur CPU du système SYST illustré à titre d'exemple était microprogrammée conformément au EP-A-0434083 pour commander le fonctionnement normal du processeur. Le mode de réalisation du procédé d'autotest qui va maintenant être décrit en référence aux figures 7, 8 et 9 utilise avantageusement des microprogrammes d'autotest STMP ajoutés aux microprogrammes commandant le fonctionnement normal de l'unité de base BPU de chaque processeur CPU. La description du procédé d'autotest se fera d'abord en référence à la figure 7, qui illustre schématiquement les opérations d'autotest effectuées par la mémoire DAT, le registre DIR et les microprogrammes d'autotest STMP des unités EAD et BDP de l'unité de traitement de base BPU. La figure 7 reprend les éléments matériels indiqués dans le processeur décrit en référence à la figure 2. On retrouve, indiqué entre parenthèses dans la figure 7, les lignes d'adresse ADR et les lignes de commande CDR entre la mémoire DAT et le registre DIR, les lignes d'adresse L-AD et les lignes de commande CD-AD entre l'unité EAD et le registre DIR, les lignes de commande CD-CB entre les unités EAD et BDP et, dans le bus interne CB, le bus RES utilisé pour transmettre les résultats à écrire dans la mémoire DAT à partir de l'unité EAD ou BDP, l'unité BDP dans l'exemple illustré, et le bus OP pour la lecture des opérandes de la mémoire DAT vers l'unité EAD ou BDP. Les signaux impliqués pour le procédé d'autotest illustré sont indiqués au côté de ces lignes et des bus RES et OP.

Le procédé d'autotest commence par un premier test vérifiant si tous les blocs BL0-BL63 de la mémoire DAT ne présentent pas de défauts de parité ou d'écriture de données prédéterminées. En pratique, ces données correspondent avantageusement à deux motifs d'adresse basse AL alternés entre deux sous-blocs adjacents SBL0-SBL255 de chaque niveau LV0-LV15. Par exemple, sachant qu'un sous-bloc a seize octets, on donnera aux adresses paires AL0, AL2, AL4,... les données AA pour chacun des octets, et aux adresses impaires AL1, AL3,... les données 55. Le premier test comprend deux phases.

La phase 1 est une phase d'écriture illustrée schématiquement dans la figure 7 par des traits continus. Le microprogramme d'autotest STMP de l'unité EAD fournit au registre DIR une commande d'écriture IOW, l'adresse basse AL puis l'adresse haute AH d'une adresse AD d'un bloc BL de la mémoire DAT. Le microprogramme d'autotest STMP de l'unité BDP synchronise celui de l'unité EAD par un signal ALGO et fournit à la mémoire DAT les données du bloc. Ces opérations sont répétées suivant une boucle assurant l'écriture des données dans tous les blocs de la mémoire DAT.

La phase 2 est une phase de lecture et de test illustrée schématiquement dans la figure 7 par des traits discontinus. Le microprogramme d'autotest STMP de l'unité EAD est synchronisé par le signal ALGO émis par l'unité BDP et fournit successivement au registre DIR toutes les adresses AD des blocs BL de la mémoire DAT et les commandes de lecture IOR des données dans les blocs respectifs. La mémoire DAT lit les données sous chaque adresse, communique ces données à l'unité BDP via le bus OP, en vérifie la parité et transmet tout défaut de parité PARER au registre DIR sur les lignes de commande CDR. L'unité BDP compare les données lues avec les données écrites correspondantes et communique les résultats WKR à l'unité EAD, qui les transmet au registre DIR par une commande DAO. En réponse, Le matériel du registre DIR écrit dans les adresses DE les marques F relatives aux blocs de DAT dans lesquels une erreur de données ou de parité a été constatée, de la façon décrite en référence à la figure 6. Le matériel du registre DIR gère aussi deux compteurs d'erreurs : un compteur DATER de tous les blocs inutilisables dans la mémoire DAT et un compteur COLER de tous les blocs inutilisables dans chaque colonne. Le compteur COLER est remis à zéro à chaque changement de colonne dans le registre DIR. Si l'un des compteurs dépasse les limites précitées, le circuit intégré est considéré comme non fonctionnel et est mis au rebut.

Le procédé d'autotest se poursuit par un second test effectué avec les valeurs complémentaires des données précédentes. Ce second test comprend deux phases 3 et 4 identiques aux phases respectives 1 et 2 et portant sur ces valeurs complémentaires. Ce second test offre donc aussi l'avantage de se faire simplement et rapidement avec des motifs alternés de valeurs complémentaires de celles du premier test. Cependant, puisque les parités sont identiques pour des données de valeurs complémentaires, les deux tests précédents ne modifient pas la parité. Le procédé d'autotest comporte donc un troisième test qui assure que la parité change d'état pour être bien testée. Ce test comprend deux phases 5 et 6 respectivement identiques aux phases 1 et 2, mais portant sur des données assurant le changement de parité. Il suffit par exemple que le dernier octet de chaque sous-bloc ait la valeur complémentaire de la valeur des autres octets. En référence aux données citées dans les deux premiers tests, on donnera au dernier octet la valeur 55 quand les octets précédents ont valeur AA, et la valeur AA quand les octets précédents ont la valeur 55. Ce test peut ainsi se faire simplement et rapidement.

Cependant, ces trois tests (phases 1-6) présentent encore un inconvénient. Dans ces tests, deux données s'alternent entre sous-blocs adjacents. Par conséquent, si le décodeur d'adresse DEC dans la mémoire DAT fonctionne mal, on peut y écrire deux fois l'une de ces données à la même adresse. Par exemple, en voulant écrire dans la phase 1 l'une des deux données (AA... ou 55...) dans les adresses AL0 et AL2, cette valeur pourra s'écrire deux fois dans l'adresse AL0 si le décodeur DEC confond les deux adresses AL0 et AL2. Avantageusement, ce même test permet de vérifier aussi si le multiplexeur des niveaux commandés par les résultats HIT0-15 fonctionne bien et ne confond pas deux niveaux. Dans un tel cas, la lecture dans les deux adresses donnera la même donnée et la comparaison sera jugée bonne alors qu'en réalité le décodeur ne peut pas accéder à l'adresse AL2. Le test sur des valeurs s'alternant ne peut donc pas déceler cette erreur. Le procédé d'autotest comporte donc un quatrième test consistant à mettre des données différentes dans chacun des sous-blocs. Dans l'exemple choisi, les 4096 sous-blocs de la mémoire DAT peuvent recevoir une donnée différente en incrémentant la valeur du registre représentant les quatre derniers octets de chaque sous-bloc. Le quatrième test comprend deux phases 7 et 8, respectivement similaires aux phases 1 et 2 mais utilisant les données différentes dans les sous-blocs pour détecter tout défaut de fonctionnement du décodeur.

Le procédé d'autotest qui vient d'être présenté se heurte encore à un autre problème. Quand l'unité EAD fait une requête sur un sous-bloc SBL de la mémoire DAT, elle fournit au registre DIR l'adresse AD = AH + ALH + ALL du bloc BL contenant le sous-bloc SBL. En d'autres termes, l'unité EAD ne peut pas donner, dans l'exemple illustré, un ordre au registre DIR pour qu'il écrive dans un niveau donné de la mémoire DAT. L'écriture dans le sous-bloc nécessite l'adresse DCA que forme le registre DIR à partir de l'adresse ALH, représentative de la colonne qui contient le bloc, et de l'adresse haute AH pour la formation des seize bits de niveaux HIT0-15. Cependant, quand le procédé d'autotest commence, la mémoire vive du registre DIR qui en fonctionnement normal contient toutes les adresses des blocs de la mémoire DAT a un contenu indéterminé. Par conséquent, si l'unité EAD fournit une adresse donnée AD au registre DIR quand commence la phase 1 d'écriture du procédé d'autotest, il y a de fortes chances pour que la comparaison dans le registre DIR n'aboutisse pas à la détermination des bits de niveaux HIT0-15. Cette détermination serait donc faite par l'algorithme LRU et échapperait à tout contrôle nécessaire pour être assuré que l'autotest a bien eu lieu sur tous les blocs de la mémoire DAT. La solution proposée consiste, au commencement du procédé d'autotest, à initialiser la mémoire vive du registre DIR en lui fournissant toutes les adresses hautes AH correspondant aux 1024 blocs de la mémoire DAT et en faisant en sorte que ces adresses hautes AH correspondent aux adresses des requêtes de l'unité EAD. Puisqu'il n'y a que 1024 blocs dans la mémoire DAT illustrée, il suffit d'utiliser une partie des vingt-quatre bits de l'adresse haute AH illustrée dans la figure 5 pour faire l'initialisation proposée. Par exemple, en utilisant les seize bits de poids forts AH0:15 de chaque adresse AH, la première requête de l'unité EAD sera AH0 + AL, la seconde AH1 + AL,... et la seizième AH15 + AL. De cette façon, tous les blocs auxquels l'unité EAD accédera avec leurs adresses AD seront présents dans l'antémémoire et leurs données pourront être comparées pour fournir les signaux HIT 0:15. En pratique, un registre REG de quatre octets, disponible dans l'unité EAD illustrée, a servi à faire l'initialisation du registre DIR. Une autre solution consisterait à rendre possible l'accès direct de l'unité EAD aux niveaux du registre DIR. Cela pourrait être fait par l'emploi d'un bus de seize bits ou d'un canal d'exploitation (scan path) entre l'unité EAD et le registre DIR.

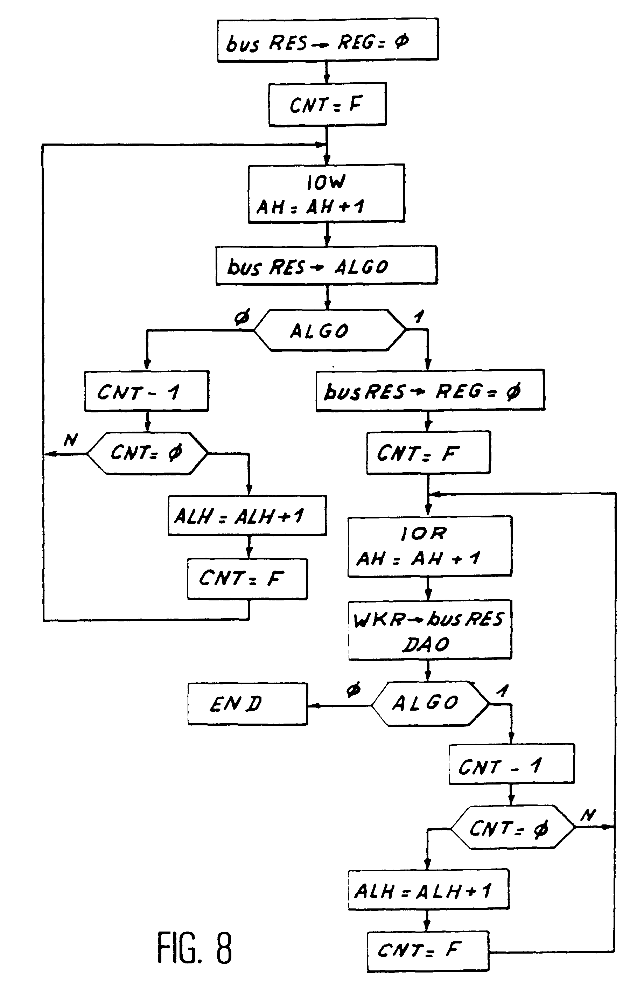

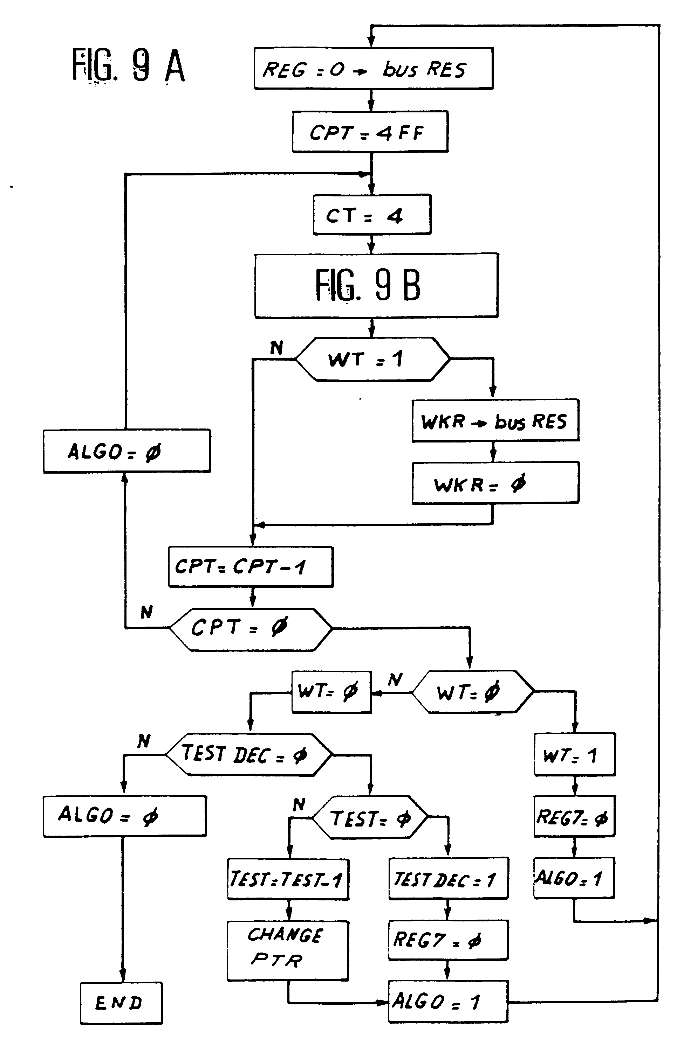

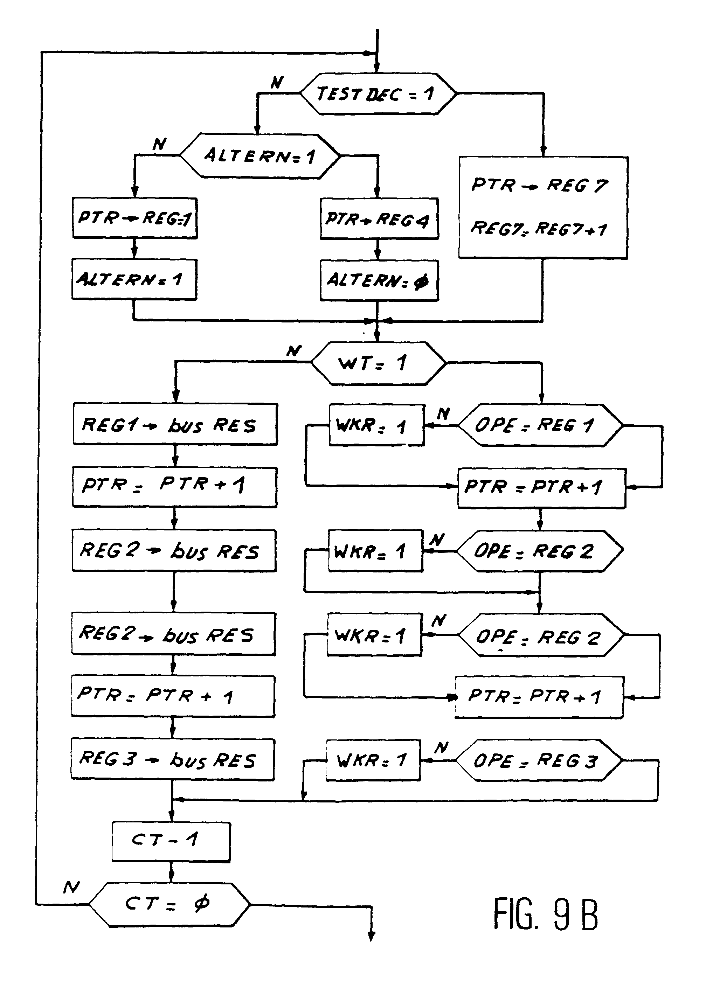

Le mode préféré d'exécution du procédé d'autotest conforme à l'invention va maintenant être décrit en détail en référence aux figures 8 et 9A-9B, qui font partie de la présente description. Les organigrammes des figures 8 et 9A-9B illustrent respectivement le fonctionnement de l'unité EAD et de l'unité BDP exécutant leurs microprogrammes d'autotest STMP. Les deux organigrammes représentent le déroulement de la phase d'écriture et de la phase de lecture-comparaison de chacun des quatre tests qui composent le procédé d'autotest qui vient d'être décrit. L'autotest est terminé quand l' unité EAD a exécuté quatre fois l'organigramme représenté sur la figure 8 sous la commande de l'unité BDP qui n'exécute qu'une fois l'organigramme représenté sur les figures 9A-9B.

En référence à la figure 8, la phase 1 du premier test commence par l'initialisation du contenu du registre REG. Ce contenu est envoyé par l'unité BDP par l'intermédiaire du bus RES. Un compteur CNT est initialisé sur la valeur logique F représentative des seize niveaux LV0-LV15 du registre DIR. Pour écrire dans le niveau LV0 de la colonne des blocs BL0 de la mémoire DAT, l'unité EAD envoie au registre DIR la commande d'écriture IOW de soixante-quatre octets. L'unité EAD attend de l'unité BDP la réception du signal de synchronisation ALGO et, à la réception, en vérifie la valeur. La valeur 0 représente la phase d'écriture et la valeur 1, la phase de lecture-comparaison. Etant à la phase 1 d'écriture, ALGO = 0. Le compteur CNT est ensuite décrémenté et l'unité EAD passe au niveau LV1. L'unité EAD fait une nouvelle commande d'écriture IOW, incrémente l'adresse haute AH et attend le signal ALGO. Le cycle d'écriture recommence jusqu'à ce que le compteur CNT = 0, qui indique que l'écriture a été faite dans le seizième niveau LV15 de la colonne des blocs BLO de la mémoire DAT. La partie haute ALH de l'adresse basse AL est alors incrémentée pour passer à la colonne COL1 dans le registre DIR et écrire dans la colonne des blocs BL1 de la mémoire DAT. Un nouveau cycle d'écriture dans tous les blocs de cette colonne recommence comme précédemment et se répète jusqu'à ce que EAD ait commandé l'écriture dans tous les blocs de la mémoire DAT. A ce stade, l'unité BDP envoie le signal de synchronisation ALGO = 1 pour commencer la phase 2 du procédé d'autotest. L'adresse haute AH est remise à zéro dans le registre REG et le compteur CNT est remis à sa valeur logique F initiale. L'unité EAD envoie au registre DIR une commande de lecture IOR et l'adresse haute AH pour lire dans le niveau LV0 de la colonne des blocs BL0 de la mémoire DAT. L'unité EAD reçoit le résultat de la comparaison faite par l'unité BDP et le transmet au registre DIR par une commande DAO. L'unité EAD reçoit aussi de l'unité BDP le signal de synchronisation ALGO. Comme à ce stade ALGO = 1, le compteur CNT est décrémenté et le cycle de lecture-comparaison est répété jusqu'à ce que le compteur CNT = 0, signifiant que la lecture-comparaison a été faite dans tous les blocs BL0. Dès lors, l'unité EAD incrémente l'adresse ALH et remet le compteur CNT à sa valeur initiale F pour fournir les adresses nécessaires à la lecture-comparaison de tous blocs de la colonne suivante. Quand l'unité EAD a fourni au registre DIR toutes les adresses des blocs de la mémoire DAT, l'unité BDP envoie le signal de synchronisation ALGO = 0, indiquant la fin de la phase 2 du procédé d'autotest et préparant le procédé à la phase d'écriture du second test. L'unité EAD recommence au début de l'organigramme pour effectuer de la même façon le second, puis le troisième et enfin le quatrième test du procédé d'autotest.

En référence à la figure 9, le procédé d'autotest exécuté par l'unité BDP commence par l'envoi à l'unité EAD, par l'intermédiaire du bus RES, de l'adresse de base zéro du registre REG. Un compteur CPT est initialisé à la valeur logique 4FF pour compter les 1024 blocs de la mémoire DAT. Un second compteur CT est initialisé à la valeur logique 4 pour compter les quatre sous-blocs SBL de chacun des blocs de la mémoire DAT. L'unité BDP vérifie ensuite l'état logique d'un signal TESTDEC relatif au test du décodeur effectué dans le quatrième test du procédé d'autotest. A l'initialisation, TESTDEC = 0, indiquant que les trois premiers tests du procédé d'autotest ne concernent pas le décodeur. L'unité BDP vérifie alors l'état logique d'un signal ALTERN commandant l'alternance des données entre sous-blocs adjacents. On a vu précédemment en référence à la figure 7 que dans la phase 1 les données écrites dans les sous-blocs étaient une alternance de valeurs logiques complémentaires A et 5. A l'initialisation ALTERN = 0. L'unité BDP place donc le pointeur PTR sur un registre REG1 de 4 octets (correspondant aux valeurs A dans la phase 1) et ALTERN est mis à la valeur 1. L'unité BDP vérifie ensuite si le procédé d'autotest est dans une phase d'écriture WT = 0 (phases 1, 3, 5 et 7 du procédé) ou dans une phase de lecture-comparaison WT = 1. A l'initialisation, WT = 0, de sorte que le contenu du registre REG1 est envoyé sur le bus RES à la mémoire DAT et que le pointeur PTR est ensuite incrémenté. Le pointeur se place donc sur un registre REG2, dont le contenu est envoyé deux fois sur le bus RES à la mémoire DAT. Le pointeur PTR est à nouveau incrémenté pour envoyer le contenu d'un registre REG3 sur le bus RES à la mémoire DAT. A ce stade, le bus a envoyé les données de seize octets du premier sous-bloc SBLO de DAT. Le compteur CT est décrémenté, de sorte que la boucle recommence à ce niveau pour le second sous-bloc SBL1. Pour ce sous-bloc, ALTERN = 1, de sorte que le pointeur PTR se positionne sur un registre REG4 (de valeurs logiques 5 en phase 1) et ALTERN est remis à la valeur 0. La boucle continue comme précédemment. Quand l'écriture est terminée dans les quatre sous-blocs SBL0-SBL3 du premier bloc BL0, CT = 0 et l'unité BDP vérifie si l'écriture doit se poursuivre. A ce stade, WT = 0 pour commander l'écriture dans le second bloc. Le compteur CPT des blocs est décrémenté et la boucle d'écriture recommence au niveau de ce compteur, en même temps que l'unité BDP envoie à l'unité EAD le signal de synchronisation ALGO = 0. Quand l'écriture dans tous les blocs est terminée, CPT = 0. A ce stade, WT passe à 1, commandant la phase de lecture-comparaison. Un registre REG7 est mis à la valeur 0 en vue d'un test du décodeur et l'unité BDP envoie à l'unité EAD le signal de synchronisation ALGO = 1. Le fonctionnement de l'unité BDP repart au début de l'organigramme qui vient d'être présenté. TESTDEC reste égal à 0 (phase 2 du procédé), de sorte que le fonctionnement de l'unité BDP passe en une phase de lecture-comparaison quand il trouve WT = 1. ALTERN a été initialisé à 0, de sorte que le pointeur PTR se place sur le registre REG1 avant d'être incrémenté. Les données de quatre octets OPE qui sont lues dans le premier sous-bloc SBL0 du bloc BL0 de la mémoire DAT sont comparées avec le contenu du registre REG1 qui été écrit dans ce sous-bloc. Si OPE diffère de REG1, un registre interne WKR est mis à 1 pour indiquer la présence d'un défaut. Si OPE = REG1, le pointeur PTR est incrémenté et les quatre octets OPE suivants sont comparés avec le contenu du registre REG2. Il en est de même pour les quatre octets OPE suivants. Le pointeur PTR est incrémenté pour comparer les quatre derniers octets OPE avec le contenu du registre REG3. A chaque fois le registre WKR est mis à 1 si un défaut de comparaison a été constaté. Le compteur CT est décrémenté et la boucle recommence pour la lecture-comparaison du sous-bloc suivant SBL1 du bloc BL0. Quand le test des quatre sous-blocs du bloc BL0 est terminé, CT = 0 et l'unité BDP vérifie si elle doit poursuivre la lecture-comparaison (WT = 1). Si oui, elle envoie à l'unité EAD le contenu du registre de défaut WKR sur le bus RES et remet ce registre à zéro. L'unité BDP décrémente le compteur CPT des blocs dans la mémoire DAT et retourne au niveau de ce compteur dans l'organigramme pour faire la lecture-comparaison du bloc suivant (BL1) en même temps qu'elle envoie à l'unité EAD le signal de synchronisation ALGO = 1. Cette boucle est refaite jusqu'à ce que le compteur CPT = 0. L'unité BDP replace alors WT à la valeur 0 pour indiquer que la phase suivante est une phase d'écriture et vérifie si TESTDEC = 0. A ce stade, la phase d'écriture est la phase 3 du second test du procédé d'autotest, de sorte que TESTDEC = 0. Elle décrémente donc un compteur de test TEST initialisé à la valeur 3 et change les pointeurs pour lire les registres REG1-4 du test suivant. On a vu en effet, en référence à la figure 7, que les données du second test sont les données complémentaires de celles du premier test. L'unité BDP envoie alors à l'unité EAD le signal de synchronisation ALGO = 1 et repart au début de l'organigramme. A la fin du second test, TESTDEC demeure à 0 et le compteur de test TEST est décrémenté pour commencer le troisième test, test de parité. Les pointeurs sont changés pour que les registres REG1-4 aient les données indiquées à titre d'exemple en référence à la figure 7. L'unité BDP envoie le signal ALGO = 1 à l'unité EAD et reprend le début de l'organigramme. A la fin du troisième test, l'unité BDP trouve TESTDEC = O et TEST = 0, représentatif du dernier test relatif au décodeur. Elle met donc TESTDEC = 1 et le registre REG7 = 0, envoie le signal ALGO = 1 à l'unité EAD et se replace au début de l'organigramme. Quand elle trouve TESTDEC = 1, le pointeur se place sur le registre REG7 de quatre octets initialisé à 0 et son contenu est incrémenté. A ce stade, WT = 1 (phase 7 d'écriture) et le contenu de REG7 est envoyé sur le bus RES à la mémoire DAT. Le dernier test se poursuit alors de la même façon que les trois précédents. La seule différence réside dans l'utilisation du registre REG7 à la place des registres REG1 et REG4 de façon à écrire des données différentes dans tous les blocs de la mémoire DAT. A la fin du test, l'unité BDP voit TESTDEC = 1 et envoie à l'unité EAD le signal de synchronisation ALGO = 0 pour signifier la fin du procédé d'autotest.

## Revendications

1. Procédé de gestion d'une mémoire (DAT) à blocs (BL) organisés en N colonnes de n niveaux, comprenant l'interdiction de l'accès à des blocs inutilisables à cause de défauts de fonctionnement, en associant les blocs inutilisables à des marques respectives (F), caractérisé en ce qu'il consiste en outre
à tester la validité de la mémoire de façon à la valider si le nombre total des blocs inutilisables dans la mémoire ne dépasse pas une proportion prédéterminée du nombre total de blocs ; et
à déterminer le nombre n de niveaux en fonction du nombre maximal de blocs inutilisables dans chacune des N colonnes,
de sorte que la mémoire peut être utilisée sans remplacement ou réparation des blocs inutilisables.

2. Procédé selon la revendication 1, caractérisé en ce que le test de validation de la mémoire consiste à la valider si le nombre de blocs inutilisables dans chacune des colonnes est inférieur ou égal à un nombre donné.

3. Procédé selon la revendication 1 ou 2, caractérisé en ce que le test de validation est fait par un procédé d'autotest de la mémoire.

4. Procédé selon l'une des revendications 1 à 3, caractérisé en ce qu'il consiste à utiliser un algorithme (LRU) de remplacement des blocs de la mémoire pour lui fournir un masque des n niveaux d'une colonne, afin que l'algorithme choisisse le niveau réservé à un bloc que la mémoire va recevoir.

5. Mémoire (DAT) à blocs (BL) organisés en N colonnes de n niveaux, dans laquelle des marques (F) sont associées à des blocs respectifs inutilisables à cause de défauts de fonctionnement, de façon à empêcher l'accès aux blocs inutilisables, caractérisée en ce qu'elle comporte
des moyens (STMP, DATER) pour tester la validité de la mémoire de façon à la valider si le nombre total des blocs inutilisables dans la mémoire ne dépasse pas une proportion prédéterminée du nombre total de blocs et
des moyens (STMP, COLER) pour déterminer le nombre n de niveaux en fonction du nombre maximal de blocs inutilisables dans chacune des N colonnes, de sorte que la mémoire peut être utilisée sans remplacement ou réparation des blocs inutilisables.

6. Mémoire selon la revendication 5, caractérisée en ce que les moyens de test incluent un premier compteur (DATER) de tous les blocs inutilisables dans la mémoire.

7. Mémoire selon la revendication 5 ou 6, caractérisée en ce que les moyens de test comprennent un premier compteur (COLER) de tous les blocs inutilisables dans chaque colonne, de façon à valider la mémoire si le nombre de blocs inutilisables dans chacune des colonnes est inférieur ou égal à un nombre donné.

8. Mémoire selon la revendications 5 à 7, caractérisée en ce que les moyens de test de validation utilisent un procédé d'autotest de la mémoire, de préférence microprogrammé dans le circuit de commande de la mémoire si elle est associée à un tel circuit.

9. Mémoire selon l'une des revendications 5 à 8, caractérisée en ce qu'elle est gérée par un algorithme (LRU) de remplacement des blocs de la mémoire pour lui fournir un masque des n niveaux d'une colonne, afin que l'algorithme choisisse le niveau réservé à un bloc que la mémoire va recevoir.

10. Système informatique comprenant au moins un processeur pourvu d'une antémémoire communiquant avec une mémoire centrale et comprenant une mémoire de données (DAT) et un registre d'adresse (DIR), caractérisé en ce que la mémoire de données est celle définie par l'une des revendications 5 à 9.

## Patentansprüche

1. Verfahren zum Verwalten eines Speichers (DAT) mit Blöcken (BL), die in N Spalten mit n Niveaus organisiert sind, enthaltend das Sperren des Zugriffs auf Blöcke, die wegen Funktionsfehlern nicht nutzbar sind, indem den nicht nutzbaren Blöcken entsprechende Markierungen (F) zugeordnet werden, dadurch gekennzeichnet, daß es außerdem darin besteht,
die Gültigkeit des Speichers in der Weise zu prüfen, daß er für gültig erklärt wird, wenn die Gesamtanzahl der nicht nutzbaren Blöcke im Speicher einen vorgegebenen Anteil der Gesamtzahl von Blöcken nicht übersteigt; und
die Anzahl n der Niveaus in Abhängigkeit von der maximalen Anzahl der nicht nutzbaren Blöcke in jeder der N Spalten zu bestimmen,
derart, daß der Speicher ohne Ersetzung oder Reparatur der nicht nutzbaren Blöcke verwendet werden kann.

2. Verfahren nach Anspruch 1, dadurch gekennzeichnet, daß die Gültigkeitsprüfung des Speichers darin besteht, ihn für gültig zu erklären, wenn die Anzahl der nicht nutzbaren Blöcke in jeder der Spalten kleiner oder gleich einer gegebenen Anzahl ist.

3. Verfahren nach Anspruch 1 oder 2, dadurch gekennzeichnet, daß die Gültigkeitsprüfung durch ein Selbstprüfungsverfahren des Speichers ausgeführt wird.

4. Verfahren nach einem der Ansprüche 1 bis 3, dadurch gekennzeichnet, daß es darin besteht, einen Algorithmus (LRU) zum Ersetzen von Blöcken des Speichers zu verwenden, um an ihn eine Maske der n Niveaus einer Spalte zu liefern, damit der Algorithmus das Niveau wählt, das für einen Block reserviert ist, den der Speicher empfängt.

5. Speicher (DAT) mit Blöcken (BL), die in N Spalten mit n Niveaus organisiert sind, in dem den Blöcken, die wegen Funktionsfehlern nicht nutzbar sind, jeweils Marken (F) zugeordnet werden, derart, daß der Zugriff auf die nicht nutzbaren Blöcke verhindert wird, dadurch gekennzeichnet, daß er enthält:
Mittel (STMP, DATER) zum Prüfen der Gültigkeit des Speichers in der Weise, daß er für gültig erklärt wird, wenn die Gesamtanzahl der nicht nutzbaren Blöcke im Speicher einen vorgegebenen Anteil der Gesamtanzahl von Blöcken nicht übersteigt, und
Mittel (STMP, COLER) zum Bestimmen der Anzahl n von Niveaus in Abhängigkeit von der maximalen Anzahl von nicht nutzbaren Blöcken in jeder der N Spalten, derart, daß der Speicher ohne Ersetzung oder Reparatur der nicht nutzbaren Blöcke verwendet werden kann.

6. Speicher nach Anspruch 5, dadurch gekennzeichnet, daß die Prüfmittel einen ersten Zähler (DATER) für sämtliche nicht nutzbaren Blöcke des Speichers enthalten.

7. Speicher nach Anspruch 5 oder 6, dadurch gekennzeichnet, daß die Prüfmittel einen ersten Zähler (COLER) sämtlicher nicht nutzbarer Blöcke in jeder Spalte enthalten, derart, daß der Speicher für gültig erklärt wird, falls die Anzahl der nicht nutzbaren Blöcke in jeder der Spalten kleiner oder gleich einer gegebenen Anzahl ist.

8. Speicher nach den Ansprüchen 5 bis 7, dadurch gekennzeichnet, daß die Gültigkeitsprüfmittel ein Selbstprüfverfahren des Speichers verwenden, das zweckmäßig in der Steuerschaltung des Speichers mikroprogrammiert ist, falls ihm eine solche Schaltung zugeordnet ist.

9. Speicher nach einem der Ansprüche 5 bis 8, dadurch gekennzeichnet, daß er durch einen Algorithmus (LRU) zum Ersetzen von Blöcken des Speichers gesteuert wird, um ihm eine Maske der n Niveaus einer Spalte zu liefern, damit der Algorithmus das Niveau wählt, das für einen Block reserviert ist, den der Speicher empfängt.

10. Datenverarbeitungssystem, das wenigstens einen Prozessor enthält, der mit einem Cache-Speicher versehen ist, der mit einem Hauptspeicher in Verbindung steht und einen Datenspeicher (DAT) sowie ein Adressenregister (DIR) enthält, dadurch gekennzeichnet, daß der Datenspeicher derjenige ist, der durch einen der Ansprüche 5 bis 9 definiert ist.

## Claims

1. Method for managing a memory (DAT) with blocks (BL) organised in N columns of n levels, comprising prohibition of access to blocks that are unusable because of operating faults, by associating unusable blocks with respective marks (F), characterised in that it further consists in:
testing the validity of the memory so as to validate it if the total number of unusable blocks in the memory does not exceed a predetermined proportion of the total number of blocks; and
determining the number n of levels as a function of the maximum number of unusable blocks in each of the N columns,
such that the memory can be used without replacing or repairing the unusable blocks.

2. Method according to Claim 1, characterised in that the memory validation test consists in validating it if the number of unusable blocks in each of the columns is less than or equal to a given number.

3. Method according to Claim 1 or 2, characterised in that the validation test is carried out by a memory self-test method.

4. Method according to one of Claims 1 to 3, characterised in that it consists in using an algorithm (LRU) for replacing the blocks of the memory in order to provide it with a mask for the n levels of a column, in order for the algorithm to choose the level reserved for a block that the memory can receive.

5. Memory (DAT) with blocks (BL) organised in N columns of n levels, in which marks (F) are associated with respective blocks that are unusable because of operating faults, so as to prevent access to unusable blocks, characterised in that it further comprises:
means (STMP, DATER) for testing the validity of the memory so as to validate it if the total number of unusable blocks in the memory does not exceed a predetermined proportion of the total number of blocks; and
means (STMP, COLER) for determining the number n of levels as a function of the maximum number of unusable blocks in each of the N columns,
such that the memory can be used without replacing or repairing the unusable blocks.

6. Memory according to Claim 5, characterised in that the test means include a first counter (DATER) for all the unusable blocks in the memory.

7. Memory according to Claims 5 or 6, characterised in that the test means comprise a first counter (COLER) for all the unusable blocks in each column, so as to validate the memory if the number of unusable blocks in each of the columns is less than or equal to a given number.

8. Memory according to Claims 5 to 7, characterised in that the validation test means use a memory self-test method, preferably firmware-based, in the control circuit of the memory if it is associated with such a circuit.

9. Memory according to one of Claims 5 to 8, characterised in that it is managed by an algorithm (LRU) for replacing the blocks of the memory in order to provide it with a mask for the n levels of a column, in order for the algorithm to choose the level reserved for a block that the memory can receive.

10. Information-processing system comprising at least one processor provided with a cache communicating with a central memory and comprising a data memory (DAT) and an address register (DIR), characterised in that the data memory is that defined by one of Claims 5 to 9.
